# EUROPÄISCHE PATENTSCHRIFT

(11) **EP 2 040 374 B1**
(45) Veröffentlichungstag und Bekanntmachung des Hinweises auf die Patenterteilung: **18.04.2012**
(21) Anmeldenummer: 08015996.5
(22) Anmeldetag: 11.09.2008
(51) Int. Cl.: H03B 11/02

(54) **Mikrowellengenerator**
Microwave generator
Générateur de micro-ondes

(30) Priorität: 20.09.2007 DE 102007044821
(43) Veröffentlichungstag der Anmeldung: 25.03.2009
(73) Patentinhaber: Diehl BGT Defence GmbH & Co.KG, 88662 Überlingen (DE)
(72) Erfinder: Stark, Robert, 91438 Bad Windsheim (DE)
(74) Vertreter: Diehl Patentabteilung

(56) Entgegenhaltungen:
- EP-A1- 1 473 866
- US-A- 3 748 528

## Beschreibung

Die Erfindung betrifft einen Mikrowellengenerator gemäß dem Oberbegriff des Anspruches 1. Ein solcher Mikrowellengenerator ist aus der EP 1 473 866 A1 und der US 3,748,528 A bekannt.

Aus der DE 10 2005 002 279 A1 ist ein Mikrowellengenerator mit zwei in einem Gehäuse vorgesehenen und über eine bei Anliegen einer Hochspannung zur Abstrahlung von Mikrowellen durchschlagenden Funkenstrecke getrennten Elektroden bekannt, wobei die eine, äußere Elektrode topfartig ausgebildet ist und die andere innere Elektrode zumindest über einen Teil ihrer Länge außenseitig beabstandet übergreift. Die topfartige, äußere Elektrode weist einen Bodenabschnitt auf, der gleichzeitig den seitlichen Abschluss des Gehäuses bildet. Die innere Elektrode ist kappen- bzw. halbkugelförmig gerundet und die Außenelektrode weist einen kleinen kugelkappenförmigen Vorsprung auf, wobei sich die beiden Elektroden am Vorsprung mit einem geringen Abstand von z. B. wenigen Millimetern gegenüberliegen.

Besonders stark korrodieren die Bereiche der Elektrodenflächen, die voneinander den geringsten Abstand besitzen. Die Entladung beschränkt sich bei, einer solchen Ausbildung auf einen sehr eng begrenzten Bereich minimalen Abstands der Elektroden-Oberflächen, so dass die Elektroden-Erosion stark ausgeprägt und die Lebensdauer des Mikrowellengenerators begrenzt ist.

Dieselben Probleme bestehen bei dem Mikrowellengenerator, wie er aus der DE 10 2005 034 295 B4 bekannt ist.

Um bei derartigen Mikrowellengeneratoren mit einer einzigen Funkenstrecke die Erosionsrate an den Elektroden zu verringern und einen stabilen und zuverlässigen Betrieb zu ermöglichen, schlägt die DE 10 2005 013 925 A1 vor, die Elektroden im Bereich der Funkenstrecke derartig auszubilden, dass sich anstelle eines quasi punktuellen ein zwei- oder dreidimensionaler Abschnitt mit im wesentlichen konstantem, minimalem Elektrodenabstand ergibt. Auch dieser bekannte Mikrowellengenerator besitzt jedoch nur eine einzige Funkenstrecke.

Ein Mikrowellengenerator mit einer einzigen Funkenstrecke, die als Ringfunkenstrecke ausgebildet ist, ist aus der DE 10 2005 044 353 A1 bekannt.

Bei Mikrowellengeneratoren, welche aus einer koaxialen Kapazität bestehen, die über eine einzige Funkenstrecke, d. h. eine Funkenstreckeneinrichtung mit einer einzigen Funkenstrecke, entladen wird, bildet diese Kapazität mit den physikalischen Eigenschaften des Schalterplasmas in der Funkenstrecke sowie in Zusammenhang mit der elektrischen Verschaltung einen Schwingkreis, der aus einem ohmschen Widerstand R, einer Induktivität L und einer Kapazität C besteht. Die Kapazität wird über eine Ladeimpedanz R, L auf Spannungen bis in den 100kV- bis MV-Bereich aufgeladen. Die zunehmende Ladespannung führt schließlich - dem Paschengesetz folgend - zum Durchbruch der Funkenstrecke. Der Durchbruch der Funkenstrecke kann auch gezielt durch einen geeigneten Triggermechanismus herbeigeführt werden.

Die physikalischen Eigenschaften der Funkenstrecke wie die Durchbruchspannung, der Umgebungsdruck, der Abstand zwischen den Funkenstrecken-Elektroden, die Plasmaimpedanz usw. bestimmen maßgeblich das Schalt- d. h. Zündverhalten der Funkenstrecken-Entladung und damit die Anstiegszeit und die Pulsform bzw. die unterschiedlichen Frequenzanteile des generierten Hochspannungspulses.

Nach dem Durchschalten der Funkenstrecke wird die im Resonator-Schwingkreis gespeicherte Energie ganz oder teilweise über eine mit dem Resonator gekoppelte Abstrahleinrichtung, d. h. Antenne, in die Umgebung des Mikrowellengenerators abgestrahlt.

Die Entkopplung des Schwingkreises vom Hochspannungsgenerator, bei dem es sich bspw. um einen Marx-Generator handelt, erfolgt durch in den Ladekreis eingebrachte Impedanzen in Form von ohmschen oder induktiven Widerständen. Die Größe der in die Umgebung abgestrahlten Energie ist maßgeblich durch die Impedanzanpassung des Schwingkreises an die Umgebung, d. h. den umgebenden Raum, bestimmt. Diese Impedanz beträgt 377Ω.

Bei einer idealen Anpassung würde die gesamte Energie in Form eines Rechteckimpulses abgestrahlt. Bei einer leichten Fehlanpassung wird ein Teil der Energie bzw. des Pulses an einem Impedanzsprung reflektiert und führt somit in Zusammenhang mit der Überlagerung von auslaufender und rücklaufender Welle zu einer Veränderung der abgestrahlten Pulsform. Durch entsprechende Anpassung des Impedanzverhältnisses ist somit eine Pulsformung des abgestrahlten Pulses erzielbar, die einer gedämpften Sinus-Schwingung gleicht.

Bei einer extremen Fehlanpassung verhält sich das System wie ein Schwingkreis hoher Güte, so dass kaum Energie in die Umgebung abgestrahlt wird. Die Energie bleibt im System und führt zu einem resonanten Schwingverhalten, bis die Energie durch die Eigenverluste des Schwingkreises verbraucht ist.

Die Anzahl der Schwingungen, d. h. die Güte des Schwingkreises pro Puls, kann durch Anpassung des Impedanzsprungs verändert werden. Angestrebt ist bei einem Mikrowellengenerator ein erzeugter Hochspannungspuls, d. h. ein elektromagnetischer Puls, der mindestens einen Schwingungszyklus bis einige zehn Schwingungszyklen durchläuft.

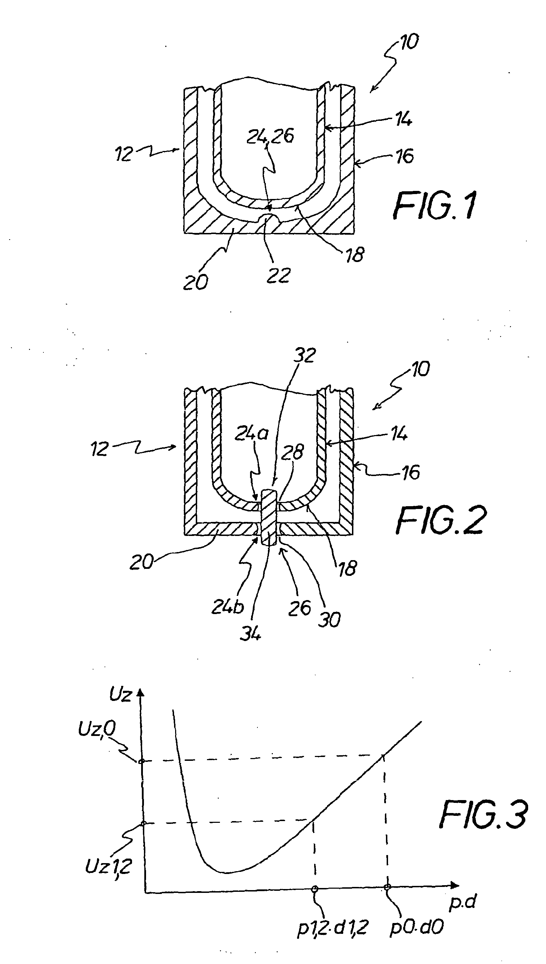

Das Zündverhalten der Funkenstreckeneinrichtung des Mikrowellengenerators wird durch die Zündspannungscharakteristik bestimmt. Die Zündspannungscharakteristik (=Paschenkurve) beschreibt den Zusammenhang zwischen dem Produkt aus dem Entladegasdruck p, dem zugehörigen Elektrodenabstand d und der Zündspannung Uz der Funkenstrecke des Mikrowellengenerators. Die Zündspannung Uz beschreibt hierbei die maximale Haltespannung, bis zu der die Funkenstrecke beaufschlagt werden kann, bis es schließlich zur Ausbildung einer Gasentladung, d. h. Funkenentladung, und damit zum Zusammenbruch der über der Funkenstrecke anliegenden Spannung kommt. Der zeitliche Verlauf des Zusammenbruchs der Spannung an der Funkenstrecke wird in erster Linie durch die Impedanz (R L) der sich ausbildenden Gas- bzw. Plasmaentladung, die Eigenkapazität der Funkenstrecke sowie deren externe Beschaltung bestimmt. Fig. 3 der anliegenden Zeichnungsfiguren stellt den qualitativen Verlauf einer Zündspannungscharakteristik, d. h. Paschenkurve Uz = f (p.d) dar. Im Allgemeinen ist die Paschenkurve für den idealen Fall planparalleler, unendlich ausgedehnter Elektroden, d. h. eines homogenen elektrischen Feldes mit idealen Oberflächen und für eine quasi statisch anliegende Spannung definiert. Im Realfall sind diese idealen Bedingungen jedoch in der Regel nicht realisierbar, da im Normalfall die Elekrodenabschnitte eng begrenzte Dimensionen aufweisen und der Elektrodenabstand in etwa in der gleichen Größenordnung wie der Elektrodendurchmesser liegt. Außerdem sind die Elektroden üblicherweise mit Verschmutzungen verunreinigt und weisen durch mechanische Bearbeitung bzw. entsprechende Fertigungsverfahren an der Elektrodenoberfläche Unebenheiten auf. Beides führt zu einer Verzerrung des elektrischen Feldes an der Elektrodenoberfläche und damit zu einer Änderung der Elektronen-Auslösearbeit. Diese Effekte beeinflussen den Entladungsaufbau bzw. das Durchbruchsverhalten der Funkenstrecke. Trotz dieser vielfältigen, unterschiedlichen Effekte, die das Durchbruchsverhalten der Funkenstrecke und damit ihre Duchbruchcharakteristik beeinflussen, zeigt der Verlauf einer realen Paschenkurve einen qualitativen Verlauf, der dem einer idealen Paschenkurve ähnlich ist.

Der Erfindung liegt die Aufgabe zugrunde, einen Mikrowellengenerator der eingangs genannten Art zu schaffen, der bei einem einfachen Aufbau in seiner Leistung gesteigert ist, und der bei höheren Zündspannungen bzw. Feldstärken betrieben werden kann.

Diese Aufgabe wird erfindungsgemäß durch die Merkmale des Anspruches 1 gelöst. Bevorzugte Aus- bzw. Weiterbildungen des erfindungsgemäßen Mikrowellengenerators sind in den Unteransprüchen gekennzeichnet.

Weitere Merkmale, Einzelheiten und Vorteile der Erfindung ergeben sich aus der nachfolgenden Beschreibung von in der Zeichnung dargestellten Ausbildungen des erfindungsgemäßen Mikrowellengenerators bzw. wesentlicher Einzelheiten desselben im Vergleich mit einem bekannten Mikrowellengenerator.

Es zeigen:
- Fig.1: abschnittweise in einer Längsschnittdarstellung eine bekannte Ausbildung des Mikrowellengenerators,
- Fig. 2: eine der Fig. 1 ähnliche abschnittweise Längsschnittdarstellung einer Ausführungsform des erfindungsgemäßen Mikrowellengenerators,
- Fig. 3: eine Diagrammdarstellung der Zündspannungscharakteristik, d. h. eine Paschenkurve einer Funkenstreckeneinrichtung eines bekanten Mikrowellengenerators mit einer von einer einzigen Funkenstrecke gebildeten Funkenstreckeneinrichtung gemäß Fig. 1 und eines erfindungsgemäßen Mikrowellengenerators mit einer Funkenstreckeneinrichtung, die zwei in Reihe geschaltete Funkenstrecken gemäß Fig. 2 aufweist,
- Fig. 4: eine der Fig. 2 entsprechende Darstellung zur Verdeutlichung der seriell verschalteten Funkenstrecken,
- Fig. 5: eine vergrößerte Darstellung des Details V in Fig. 4,
- Fig. 6A bis 6D: diverse Elektrodenkonfigurationen - ähnlich der Fig. 5,
- Fig. 7: eine der Fig. 2 prinzipiell ähnliche abschnittweise Längsschnittdarstellung noch einer anderen Ausbildung des erfindungsgemäßen Mikrowellengenerators bzw. seiner Funkenstreckeneinrichtung mit drei seriellen Funkenstrecken,
- Fig. 8: eine der Fig. 7 prinzipiell ähnliche Ausführungsform eines Mikrowellengenerators mit vier seriellen Funkenstrecken, die durch drei voneinander axial beabstandete Leiterteile bestimmt sind, und
- Fig. 9: eine den Figuren 7 oder 8 ähnliche abschnittweise Längsschnittdarstellung einer Ausführungsform des Mikrowellengenerators, bei dem die Funkenstreckeneinrichtung durch voneinander radial beabstandete Leiterteile bestimmt ist.

Fig. 1 verdeutlicht abschnittweise längsgeschnitten wesentliche Teile eines bekannten Mikrowellengenerators 10 mit einem Resonator 12, der eine Innenelektrode 14 und eine Außenelektrode 16 aufweist, die voneinander definiert beabstandet einander gegenüberliegen. Die Innenelektrode 14 ist keulenartig und die Außenelektrode 16 ist topfartig ausgebildet. Die topfartige Außenelektrode 16 übergreift die keulenartige Innenelektrode 14. Die Innenelektrode 14 und die Außenelektrode 16 sind rotationssymmetrisch ausgebildet und zueinander koaxial angeordnet. Die Innenelektrode 14 ist mit einer konvex sphärischen Stirnfläche 18 ausgebildet. Die topfartige Außenelektrode 16 weist einen Boden 20 auf, der innenseitig mit einer zentralen Erhebung 22 ausgebildet ist. Zwischen der Erhebung 22 des Bodens 20 der Außenelektrode 16 und der Stirnfläche 18 der Innenelektrode 14 ist eine Funkenstrecke 24 ausgebildet. Diese eine Funkenstrecke 24 bildet die Funkenstreckeneinrichtung 26 des Resonators 12 des bekannten Mikrowellengenerators 10.

Fig. 2 verdeutlicht eine Ausbildung des erfindungsgemäßen Mikrowellengenerators 10, bei welchem die Funkenstreckeneinrichtung 26 zwei in Serie geschaltete Funkenstrecken 24a und 24b aufweist. Zu diesem Zwecke ist die keulenartige Innenelektrode 14 des Resonators 12 mit einem zentralen ersten Loch 28 und der Boden 20 der topfförmigen Außenelektrode 16 mit einem zentralen zweiten Loch 30 ausgebildet, wobei sich durch das erste und das zweite Loch 28 und 30 - von den Lochrändern beabstandet - eine Leitereinrichtung 32 hindurcherstreckt. Bei der Ausbildung gemäß Fig. 2 ist die Leitereinrichtung 32 von einem einteiligen Leiterelement 34 gebildet.

Die serielle Anordnung der Funkenstrecken 24a und 24b kann während der Aufladephase des Resonators 12 als eine serielle Verschaltung von Kapazitäten betrachtet werden. Bei der seriellen Verschaltung mehrerer Kapazitäten verteilt sich die gesamte anliegende Spannung über die Anzahl der Kapazitäten. Die Gesamtspannung ergibt sich aus der Summe der einzelnen anliegenden Spannungen.

Das Grundprinzip der seriellen Verschaltung von mindestens zwei Funkenstrecken ist in unterschiedlichen geometrischen Anordnungen realisierbar.

In der Praxis bedeutet dies, dass sich bei einer seriellen Verschaltung von bspw. zwei Funkenstrecken 24a und 24b gegenüber einer einzigen Funkenstrecke 24 (s. Fig. 1) bei gleicher Gesamtspannung Uz,0 am Resonator 12 die Spannungsbelastung an den einzelnen seriellen Funkenstrecken 24a, 24b halbiert, wenn die besagten Funkenstrecken 24, 24b gleich groß sind. Werden die beiden seriellen Funkenstrecken 24a, 24b jeweils wieder mit der Spannung Uz,0 (s. Fig. 3) bei entsprechend hohen p.d-Werten beaufschlagt, so ist im Idealfall, d. h. bei identischen Funkenstrecken-Konfigurationen der einzelnen Funkenstrecken 24a, 24b, der Vernachlässigung von Verlustprozessen, sekundären Kapazitäten usw. die maximal mögliche Gesamtspannung zum Betrieb des Resonators 12 quasi nahezu verdoppelbar, was auch wesentlich vom tatsächlichen Verlauf der individuellen Zündspannungscharakteristik der Funkenstrecken 24a, 24b in den unterschiedlichen Konfigurationen abhängig ist. Damit lässt sich die Leistung des Resonators 12 bzw. die abgestrahlte Feldstärke deutlich steigern.

Fig. 3 zeigt in einer Diagrammdarstellung die Zündspannungen Uz,1,2 und die zugehörigen p.d-Werte p1,2.d1,2 bei Verwendung einer seriellen Anordnung von zwei Funkenstrecken 24a, 24b sowie die Zündspannung Uz,0 und den zugehörigen p.d-Wert p0.d0 einer einzelnen Funkenstrecke 24 (s. Fig. 1) bei identischer Spannungsbelastung Uz,0 des Resonators 12. Im Idealfall verteilt sich bei einer seriellen Verschaltung zweier Funkenstrecken 24a und 24b die Gesamtspannung gleichmäßig auf die beiden seriellen Funkenstrecken. Das würde beim Betrieb des Resonators 12 einem deutlich geringeren p.d-Wert p1,2.d1,2 der einzelnen seriellen Funkenstrecken 24a, 24b entsprechen. Wird nun die serielle Funkenstreckenanordnung bei höheren p.d-Werten, d. h. bei p.d >p1,2xd1,2 betrieben, so kann die Betriebsspannung des Resonators 12 deutlich erhöht werden.

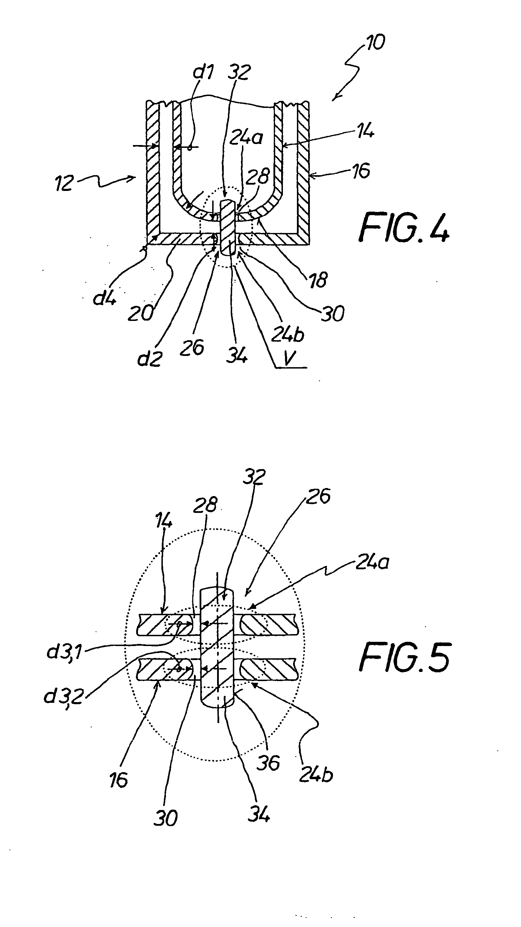

Die Figuren 4 bzw. 5 verdeutlichen eine serielle Funkenstreckenanordnung des Resonators 12 des Mikrowellengenerators 10 gemäß Fig. 2, wobei die Abstände d1, d2 und d4 frei wählbar sind, und wobei d1, d2, d4 >d3,1 und d3,2 sind. Des Weiteren kann d3,1>d3,2 oder d3,1<d3,2 oder d3,1=d3,2 sein. Bei einer speziellen Ausbildung kann d1=d2=d4>d3,1 und/oder d3,2 sein. Auch hier kann d3,1=d3,2 sein.

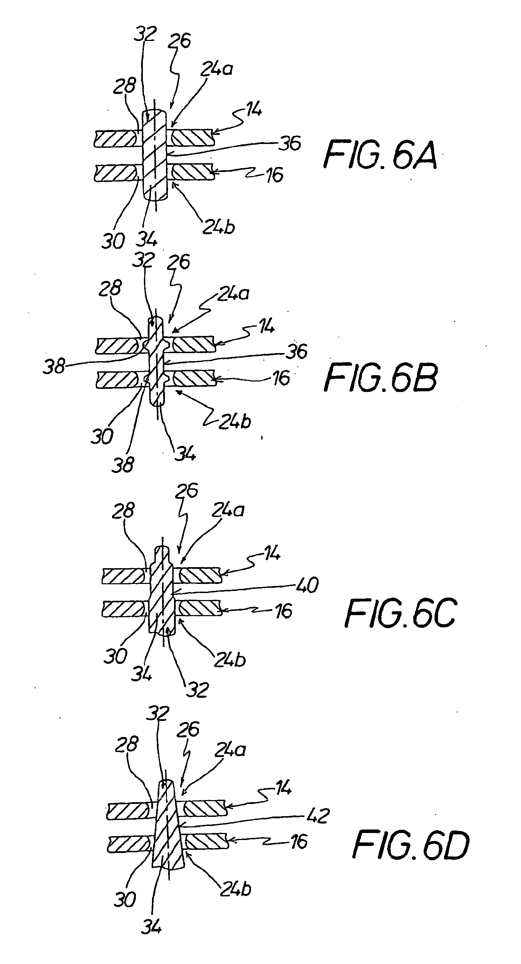

Das Grundprinzip der seriellen Verschaltung von mindestens zwei Funkenstrecken 24a, 24b, .... 24i ist in unterschiedlichen geometrischen Variationen möglich. Einige dieser Variationen - ohne darauf beschränkt zu sein - sind in den Figuren 6A bis 6D dargestellt. Diese Ausbildungen verdeutlichen jeweils ein einteiliges Leiterelement 34, das gemäß Fig. 6A eine zylindrische Außenoberfläche 36 aufweist. Das einteilige Leiterelement 34 gemäß Fig. 6B weist eine zylindrische Außenoberfläche 36 auf, die mit umlaufenden Wülsten 38 ausgebildet ist. Die Wülste 38 weisen voneinander einen axialen Abstand auf, der dem axialen Abstand zwischen der ersten und zweiten Elektrode 14 und 16 entspricht.

Fig. 6C verdeutlicht eine Ausbildung, bei welcher das Leiterelement 34 eine abgestuft zylindrische Oberfläche 40 aufweist. Die Fig. 6D zeigt eine Ausführungsform, bei der das Leiterelement 34 eine kegelige Außenoberfläche 42 aufweist.

Für die in den Figuren 6A bis 6D exemplarisch aber nicht beschränkend verdeutlichten Ausführungsformen der Funkenstrecken 24a, 24b gelten der prinzipielle Charakter der seriellen Verschaltung sowie die in Verbindung mit den Figuren 4 und 5 angegebenen Relationen bezüglich der Elektrodenabstände d1, d2 und d4 bzw. der Funkenstreckenabstände d3,1, d3,2.

Die rotationssymmetrische Geometrie der Funkenstrecken 24a, 24b, .... 24i gemäß den Figuren 6A bis 6D bzw. den Figuren 7, 8 und 9 erlaubt durch die Bereitstellung größerer Entladeoberflächen in vorteilhafter Weise eine wesentliche Erhöhung der Standzeit und damit der Lebensdauer der Funkenstreckenelektroden.

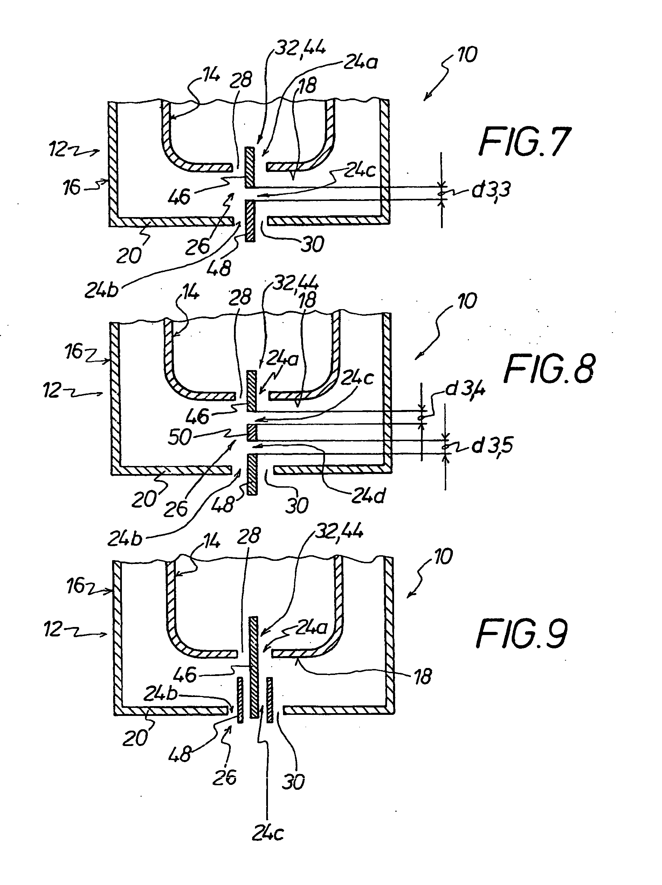

Die Fig. 7 verdeutlicht schematisch eine Ausbildung des Mikrowellengenerators 10 bzw. seines Resonators 12, wobei die sich durch das erste Loch 28 und das zweite Loch 30 der Elektroden 14 und 16 erstreckende Leitereinrichtung 32 von einem zweiteiligen Leitergebilde 44 gebildet ist. Das Leitergebilde 44 besteht aus zwei miteinander axial fluchtenden Leiterteilen 46 und 48. Das eine Leiterteil 46 ist dem ersten Loch 28 und das zweite Leiterteil 48 ist dem zweiten Loch 30 zugeordnet. Die beiden Leiterteile 46 und 48 besitzen voneinander einen Abstand d3,3, durch den eine weitere, d. h. dritte Funkenstrecke 24c definiert ist.

Fig. 8 verdeutlicht in einer der Fig. 7 ähnlichen Darstellung eine Ausbildung, bei welcher das Leitergebilde 44 drei Leiterteile 46, 48 und 50 aufweist, die miteinander axial fluchten und voneinander definiert beabstandet sind. Das Leiterteil 46 ist dem ersten Loch 28 und das Leiterteil 48 ist dem zweiten Loch 30 zugeordnet. Das Leiterteil 50 befindet sich zwischen den Leiterteilen 46 und 48 und ist von diesen durch Abstände d3,4 und d3,5 beabstandet, wobei für d3,4 und d3,5 das oben zu d3,3 und zu d3,1 und d3,2 gesagte entsprechend gilt. Die Abstände d3,4 und d3,5 definieren weitere Funkenstecken 24c und 24d.

Während die Figuren 7 und 8 Ausbildungen verdeutlichen, bei welchen die Leiterteile 46, 48, 50 miteinander axial fluchten, verdeutlicht die Fig. 9 eine Ausbildung, bei welcher die Leiterteile 46 und 48 voneinander radial beabstandet sind, um eine entsprechende Anzahl Funkenstrecken 24a, 24b und 24c zu verwirklichen.

### Bezugsziffernliste:

- 10: Mikrowellengenerator
- 12: Resonator (von 10)
- 14: Innenelektrode (von 12)
- 16: Außenelektrode (von 12)
- 18: Stirnfläche (von 14)
- 20: Boden (von 16)
- 22: Erhebung (an 20)
- 24: Funkenstrecke (von 12 bzw. 26)
- 26: Funkenstreckeneinrichtung (von 12)
- 28: Loch (in 14)
- 30: Loch (in 20)
- 32: Leitereinrichtung (von 10)
- 34: Leiterelement (von 32)
- 36: Zylindrische Außenoberfläche (von 34)
- 38: Wülste (an 36)
- 40: abgestuft glatte zylindrische Oberfläche (von 34)
- 42: Kegelige Außenoberfläche (von 34)
- 44: Leitergebilde
- 46: Leiterteil (von 44)
- 48: Leiterteil (von 44)
- 50: Leiterteil (von 44)

## Patentansprüche

1. Mikrowellengenerator mit einem Resonator (12), der zwei einander gegenüberliegende Resonator-Elektroden (14, 16) aufweist, die mit einer bei Anliegen einer Zündspannung (Uz) durchschlagenden Funkenstreckeneinrichtung (26) ausgebildet sind,
wobei die Funkenstreckeneinrichtung (26) mindestens zwei in Serie geschaltete Funkenstrecken (24a, 24b, .... 24i) aufweist,
**dadurch gekennzeichnet,**
**dass** der Resonator (12) eine keulenartige Innenelektrode (1) und eine diese übergreifende topfartige Außenelektrode (16) aufweist, die zueinander koaxial angeordnet sind, wobei die Innenelektrode (14) an ihrer dem Boden (20) der Außenelektrode (16) zugewandten Stirnfläche (18) mit einem ersten Loch (28) und der Boden (20) der Außenelektrode (16) mit einem zweiten Loch (30) ausgebildet ist, wobei das erste und das zweite Loch (28 und 30) miteinander axial fluchten, und sich durch das erste und das zweite Loch (28 und 30), von diesen beabstandet, eine Leitereinrichtung (32) erstreckt.

2. Mikrowellengenerator nach Anspruch 1,
**dadurch gekennzeichnet,**
**dass** das erste und zweite Loch (28 und 30) denselben Lochdurchmesser besitzen.

3. Mikrowellengenerator nach Anspruch 1,
**dadurch gekennzeichnet,**
**dass** das erste und zweite Loch (28 und 30) unterschiedliche Lochdurchmesser besitzen.

4. Mikrowellengenerator nach Anspruch 1,
**dadurch gekennzeichnet,**
**dass** die sich durch das erste und zweite Loch (28 und 30) erstreckende Leitereinrichtung (32) von einem einteiligen Leiterelement (34) gebildet ist.

5. Mikrowellengenerator nach Anspruch 4,
**dadurch gekennzeichnet,**
**dass** das einteilige Leiterelement (34) eine zylindrische Außenoberfläche (36) aufweiset.

6. Mikrowellengenerator nach Anspruch 4,
**dadurch gekennzeichnet,**
**dass** das einteilige Leiterelement (34) eine kegelige Außenoberfläche (42) aufweist.

7. Mikrowellengenerator nach Anspruch 5 oder 6,
**dadurch gekennzeichnet,**
**dass** das einteilige Leiterelement (34) eine glatte Außenoberfläche aufweist.

8. Mikrowellengenerator nach Anspruch 5 oder 6,
**dadurch gekennzeichnet,**
**dass** das einteilige Leiterelement (34) eine abgestuft glatte Außenoberfläche (40) aufweist.

9. Mikrowellengenerator nach Anspruch 5 oder 6,
**dadurch gekennzeichnet,**
**dass** das einteilige Leiterelement (34) mit axial voneinander beabstandeten Wülsten (38) ausgebildet ist.

10. Mikrowellengenerator nach Anspruch 9,
**dadurch gekennzeichnet,**
**dass** die Wülste (38) in den Löchern (28, 30) der Elektroden (14, 16) positioniert sind.

11. Mikrowellengenerator nach Anspruch 1,
**dadurch gekennzeichnet,**
**dass** die sich durch das erste und das zweite Loch (28 und 30) erstreckende Leitereinrichtung (32) von einem mehrteiligen Leitergebilde (44) gebildet ist.

12. Mikrowellengenerator nach Anspruch 11,
**dadurch gekennzeichnet,**
**dass** das mehrteilige Leitergebilde (44) aus mindestens zwei Leiterteilen (46, 48, 50) gebildet ist.

13. Mikrowellengenerator nach Anspruch 12,
**dadurch gekennzeichnnzet,**
dass die mindestens zwei Leiterteile (46, 48, 50) voneinander axial beabstandet sind.

14. Mikrowellengenerator nach Anspruch 12,
**dadurch gekennzeichnet,**
**dass** die mindestens zwei Leiterteile (46, 48, 50) voneinander radial beabstandet sind.

## Claims

1. Microwave generator with a resonator (12), which has two mutually opposite resonator electrodes (14, 16), which are formed with a spark gap device (26) which breaks down when an ignition voltage (Uz) is applied, the spark gap device (26) having at least two spark gaps (24a, 24b, ... 24i) connected in series, **characterized in that** the resonator (12) has a lobe-like inner electrode (14) and a pot-like outer electrode (16) engaging over said inner electrode, which electrodes are arranged coaxially with respect to one another, the inner electrode (14) being formed on its end face (18) facing the base (20) of the outer electrode (16) with a first hole (28), and the base (20) of the outer electrode (16) being formed with a second hole (30), the first and the second holes (28 and 30) being aligned axially with respect to one another, and a conductor device (32) extending through the first and the second holes (28 and 30), spaced apart from them.

2. Microwave generator according to Claim 1, **characterized in that** the first and the second holes (28 and 30) have the same hole diameter.

3. Microwave generator according to Claim 1, **characterized in that** the first and second holes (28 and 30) have different hole diameters.

4. Microwave generator according to Claim 1, **characterized in that** the conductor device (32), which extends through the first and second holes (28 and 30), is formed by an integral conductor element (34).

5. Microwave generator according to Claim 4, **characterized in that** the integral conductor element (34) has a cylindrical outer surface (36).

6. Microwave generator according to Claim 4, **characterized in that** the integral conductor element (34) has a conical outer surface (42).

7. Microwave generator according to Claim 5 or 6, **characterized in that** the integral conductor element (34) has a smooth outer surface.

8. Microwave generator according to Claim 5 or 6, **characterized in that** the integral conductor element (34) has a graduated smooth outer surface (40).

9. Microwave generator according to Claim 5 or 6, **characterized in that** the integral conductor element (34) is formed with axially spaced-apart beads (38).

10. Microwave generator according to Claim 9, **characterized in that** the beads (38) are positioned in the holes (28, 30) of the electrodes (14, 16).

11. Microwave generator according to Claim 1, **characterized in that** the conductor device (32), which extends through the first and the second holes (28 and 30), is formed by a multi-part conductor structure (44).

12. Microwave generator according to Claim 11, **characterized in that** the multi-part conductor structure (44) is formed from at least two conductor parts (46, 48, 50).

13. Microwave generator according to Claim 12, **characterized in that** the at least two conductor parts (46, 48, 50) are spaced axially apart from one another.

14. Microwave generator according to Claim 12, **characterized in that** the at least two conductor parts (46, 48, 50) are spaced radially apart from one another.

## Revendications

1. Générateur de micro-ondes comportant un résonateur (12) qui comprend deux électrodes de résonateur mutuellement opposées (14, 16) conçues sous la forme d'un dispositif éclateur (26) perforant lors de l'application d'une tension d'allumage (Uz),
dans lequel le dispositif éclateur (26) comprend au moins deux éclateurs connectés en série (24a, 24b, ... 24i)
**caractérisé en ce que**
le résonateur (12) comprend une électrode interne en forme de lobe (1) et une électrode externe en forme de pot (16) la chevauchant, qui sont disposées coaxialement l'une par rapport à l'autre, l'électrode interne (14) étant réalisée de façon à comporter un premier trou (28) sur sa face avant (18) qui est adjacente à la partie inférieure (20) de l'électrode externe (16) et un second trou (30) dans la partie inférieure (20) de l'électrode externe (16), les premier et second trous (28 et 30) étant axialement alignés l'un avec l'autre, et **en ce qu'**un moyen conducteur (32) s'étend à travers les premier et second trous (28 et 30) en étant espacés de ceux-ci.

2. Générateur de micro-ondes selon la revendication 1, **caractérisé en ce que** les premier et second trous (28 et 30) ont des diamètres de trous identiques.

3. Générateur de micro-ondes selon la revendication 1, **caractérisé en ce que** les premier et second trous (28 et 30) ont des diamètres de trous différents.

4. Générateur de micro-ondes selon la revendication 1, **caractérisé en ce que** le moyen conducteur (32) s'étendant à travers les premier et second trous (28 et 30) est constitué d'un élément conducteur monolithique (34).

5. Générateur de micro-ondes selon la revendication 4, **caractérisé en ce que** l'élément conducteur monolithique (34) présente une surface extérieure cylindrique (36).

6. Générateur de micro-ondes selon la revendication 4, **caractérisé en ce que** l'élément conducteur monolithique (34) présente une surface extérieure conique (42).

7. Générateur de micro-ondes selon la revendication 5 ou 6, **caractérisé en ce que** l'élément conducteur monolithique (34) présente une surface extérieure lisse.

8. Générateur de micro-ondes selon la revendication 5 ou 6, **caractérisé en ce que** l'élément conducteur monolithique (34) présente une surface extérieure lisse étagée (40).

9. Générateur de micro-ondes selon la revendication 5 ou 6, **caractérisé en ce que** l'élément conducteur monolithique (34) est réalisé de manière à comporter des bourrelets axialement espacés l'un de l'autre (38).

10. Générateur de micro-ondes selon la revendication 9, **caractérisé en ce que** les bourrelets (38) sont positionnés dans les trous (28, 30) des électrodes (14, 16).

11. Générateur de micro-ondes selon la revendication 1, **caractérisé en ce que** le moyen conducteur (32) s'étendant à travers les premier et second trous (28 et 30) est constitué d'une structure conductrice en plusieurs parties (44).

12. Générateur de micro-ondes selon la revendication 11, **caractérisé en ce que** la structure conductrice en plusieurs parties (44) est constituée d'au moins deux parties conductrices (46, 48, 50).

13. Générateur de micro-ondes selon la revendication 12, **caractérisé en ce que** les au moins deux parties conductrices (46, 48, 50) sont axialement espacées l'une de l'autre.

14. Générateur de micro-ondes selon la revendication 12, **caractérisé en ce que** les au moins deux parties conductrices (46, 48, 50) sont radialement espacées l'une de l'autre.
